# EUROPÄISCHE PATENTSCHRIFT

(11) **EP 2 939 278 B1**
(45) Veröffentlichungstag und Bekanntmachung des Hinweises auf die Patenterteilung: **18.04.2018**
(21) Anmeldenummer: 13818222.5
(22) Anmeldetag: 20.12.2013
(51) Int. Cl.: H01L 35/04, H01L 35/32

(54) **WÄRMEÜBERTRAGER**
HEAT EXCHANGER
ÉCHANGEUR THERMIQUE

(30) Priorität: 28.12.2012 DE 102012224486
(43) Veröffentlichungstag der Anmeldung: 04.11.2015
(73) Patentinhaber: Mahle International GmbH, 70376 Stuttgart (DE)
(72) Erfinder: GRÜNWALD, Jürgen, 71638 Ludwigsburg (DE); NEUMEISTER, Dirk, 70374 Stuttgart (DE)
(74) Vertreter: Grauel, Andreas
(86) Internationale Anmeldenummer: PCT/EP2013/077783
(87) Internationale Veröffentlichungsnummer: WO 2014/102204

(56) Entgegenhaltungen:
- EP-A2- 0 878 851
- JP-A- H08 178 498
- JP-A- 2000 164 945
- JP-A- 2002 232 028
- US-A- 3 632 451
- US-A1- 2010 291 414

## Beschreibung

### Technisches Gebiet

Die Erfindung betrifft einen Wärmeübertrager, welcher zumindest ein erstes Peltierelement aufweist, wobei das Peltierelement eine erste Halbleiteranordnung und zumindest eine zweite Halbleiteranordnung aufweist, wobei jede Halbleiteranordnung einen ersten Halbleiter, einen zweiten Halbleiter und eine elektrische Kontaktierung aufweist, wobei jeweils zumindest ein Halbleiter jeder Halbleiteranordnung aus einem p-dotierten Halbleitermaterial gefertigt ist und jeweils zumindest ein Halbleiter aus einem n-dotierten Halbleitermaterial gefertigt ist, wobei jeweils ein n-dotierter Halbleiter und ein p-dotierter Halbleiter innerhalb der Halbleiteranordnung abwechselnd elektrisch in Reihe geschaltet sind und über die elektrische Kontaktierung eine Spannung an sie anlegbar ist.

### Stand der Technik

In technischen Systemen, wie insbesondere einem Kraftfahrzeug, sind verschiedene Heiz- und Kühlaufgaben zu bewerkstelligen. Hierfür wird eine Vielzahl von verschiedenen Wärmeübertragern eingesetzt, die entsprechend der Anforderung Wärme abgeben können oder Wärme aufnehmen und diese abführen können.

Diese Wärmeübertrager stoßen an ihre Grenzen, wenn eine Abkühlung unter die Umgebungstemperatur erfolgen soll oder eine Aufheizung auf ein Temperaturniveau erfolgen soll, welches über die heißeste Wärmequelle im technischen System, im Falle eines Kraftfahrzeuges die vom Verbrennungsmotor erzeugte Abwärme, nicht erreicht werden kann. In diesem Falle muss eine aktive Kühlung beziehungsweise eine aktive Aufheizung erfolgen.

Eine solche aktive Kühlung kann beispielsweise durch eine thermische Anbindung des zu kühlenden Elements an einen vorhandenen Kühlkreislauf erfolgen. Die aktive Aufheizung kann beispielsweise durch eine Wärmepumpe, einen Brennstoffzuheizer oder einen elektrischen Heizer erfolgen. Im Stand der Technik ist eine Vielzahl von Lösungen beschrieben.

Weiterhin lassen sich zur Aufheizung oder Abkühlung auch Peltierelemente als Wärmeübertrager einsetzen. Dies ist insbesondere für die Kühlung und Aufheizung von Elektronikkomponenten in Elektro- und Hybridfahrzeugen denkbar.

Die Verwendung von Peltierelementen ist dabei besonders vorteilhaft, da keine direkte Anbindung an Kältemittelkreisläufe zur Abkühlung einzelner Elemente erfolgen muss. Weiterhin sind in Peltierelementen keine beweglichen Teile verbaut, wodurch die Komplexität des Aufbaus gering ist.

Die US 4314008 offenbart beispielsweise ein Batteriesystem mit einer aktiven Kühlung der Batteriezellen. Zu Kühlung der Batteriezellen werden hier Peltierelemente verwendet. Ein Peltierelemente besteht dabei aus einer Mehrzahl von n-dotierten Halbleitern und p-dotierten Halbleitern, die zwischen zwei parallel zueinander liegenden Isolationsplatten angeordnet sind.

Die einzelnen n-dotierten Halbleiter und p-dotierten Halbleiter sind dabei in einer Serienschaltung angeordnet. Die Aneinanderreihung der n-dotierten Halbleiter und p-dotierten Halbleiter erfolgt abwechselnd. Je nach Polarität der angelegten Spannung wird Wärme von einer Isolationsplatte zur gegenüberliegenden Isolationsplatte durch die n-dotierten Halbleiter und p-dotierten Halbleiter gefördert. Durch Umkehrung der Polarität wird die Richtung des Wärmetransportes umgekehrt.

Die JP2000164945 offenbart ein Peltierelement gemäß dem Oberbegriff von Anspruch 1.

Nachteilig an den Lösungen gemäß dem Stand der Technik ist, dass die einzelnen n-dotierten Halbleiter und die p-dotierten Halbleiter des Peltierelementes in Reihe geschaltet sind. Durch die Beschädigung eines einzelnen n-dotierten Halbleiters oder p-dotierten Halbleiters wird der gesamte Stromfluss durch das Peltierelement blockiert, wodurch das Peltierelement ausfällt.

### Darstellung der Erfindung, Aufgabe, Lösung, Vorteile

Daher ist es die Aufgabe der vorliegenden Erfindung einen Wärmeübertrager bereitzustellen, der dazu geeignet ist Elemente aktiv zu beheizen oder abzukühlen, wobei der Wärmeübertrager eine hohe Sicherheit gegen einen Ausfall aufweist und gleichzeitig einfach und kostengünstig herzustellen ist.

Die Aufgabe der vorliegenden Erfindung wird durch einen Wärmeübertrager mit den Merkmalen des Anspruchs 1 gelöst.

Ein Ausführungsbeispiel der Erfindung betrifft einen Wärmeübertrager, welcher zumindest ein erstes Peltierelement aufweist, wobei das Peltierelement eine erste Halbleiteranordnung und zumindest eine zweite Halbleiteranordnung aufweist, wobei jede Halbleiteranordnung einen ersten Halbleiter, einen zweiten Halbleiter und eine elektrische Kontaktierung aufweist, wobei jeweils zumindest ein Halbleiter jeder Halbleiteranordnung aus einem p-dotierten Halbleitermaterial gefertigt ist und jeweils zumindest ein Halbleiter aus einem n-dotierten Halbleitermaterial gefertigt ist, wobei jeweils ein n-dotierter Halbleiter und ein p-dotierter Halbleiter innerhalb der Halbleiteranordnung abwechselnd elektrisch in Reihe geschaltet sind und über die elektrische Kontaktierung eine Spannung an sie anlegbar ist, wobei die beiden Halbleiteranordnungen elektrisch parallel zueinander geschaltet sind, wobei der Wärmeübertrager eine Mehrzahl von Peltierelementen aufweist, die untereinander elektrisch in Reihe geschaltet sind. Die Parallelschaltung der einzelnen Halbleiteranordnungen in einem Peltierelement ist insbesondere vorteilhaft, da bei einem Defekt eines einzelnen Halbleiters nur der Stromfluss durch eine Halbleiteranordnung, in welcher die Halbleiter in Reihe geschaltet sind, unterbrochen wird, nicht aber der Stromfluss durch das gesamte Peltierelement. Das Peltierelement bleibt damit trotz des Ausfalls eines Halbleiters und damit einer Halbleiteranordnung zu großen Teilen funktionsfähig.

Bei einem Peltierelement mit vollständig in Reihe geschalteten Halbleitern führt ein Defekt an nur einem Halbleiter oder einem elektrischen Brückenelement zum Ausfall des gesamten Peltierelementes. Sind mehrere solche Peltierelemente in Reihe zueinander geschaltet, wird die gesamte Schaltung funktionsunfähig.

Bei der erfindungsgemäßen Anordnung und Verschaltung der einzelnen Halbleiter, Halbleiteranordnungen und Peltierelemente ist somit die Ausfallsicherheit wesentlich höher.

Weiterhin kann es besonders vorteilhaft sein, wenn die Halbleiter innerhalb der Halbleiteranordnungen über elektrisch leitende Brückenelemente miteinander verschaltet sind.

Die elektrisch leitenden Brückenelemente schaffen eine elektrische Verbindung zwischen den einzelnen Halbleitern einer Halbleiteranordnung. Die elektrischen Brückenelemente verbinden dabei jeweils einen n-dotierten Halbleiter und einen p-dotierten Halbleiter miteinander.

Ein weiteres bevorzugtes Ausführungsbeispiel ist dadurch gekennzeichnet, dass beim Anlegen einer Spannung sich jeweils ein erster Endbereich der Halbleiter erwärmt und ein diesem Endbereich gegenüberliegender Endbereich abkühlt, wobei die Halbleiter derart angeordnet sind, dass die sich erwärmenden und die sich abkühlenden Bereiche jeweils in die gleiche Richtung orientiert sind.

Die Ausrichtung der Halbleiter derart, dass die sich erwärmenden und die sich abkühlenden Endbereiche jeweils in eine gemeinsame Richtung orientiert sind ist besonders vorteilhaft, da auf diese Weise ein gerichteter Wärmetransport entlang der einzelnen Halbleiter stattfinden kann. Es entsteht somit an den Halbleiteranordnungen beziehungsweise an den Peltierelementen, bei angelegter Spannung, ein Wärmegefälle. Dies kann dazu genutzt werden, Wärme von einem zu kühlenden Element abzuführen oder einem zu erwärmenden Element zuzuführen.

Auch ist es zu bevorzugen, wenn jedes Peltierelement ein erstes Isolationselement und ein zweites Isolationselement aufweist, wobei die Halbleiter zwischen den Isolationselementen in einer Ebene angeordnet sind und die Halbleiter in thermisch leitendem Kontakt mit den elektrisch leitenden Brückenelementen und/oder den Isolationselementen sind.

Die Isolationselemente dienen in erster Linie der elektrischen Isolation der Halbleiter nach außen hin. Dies ist notwendig um den Stromfluss durch die Halbleiter nicht zu beeinflussen oder Kurzschlüsse zu verursachen.

Die Isolationselemente sollen dabei vorteilhafterweise eine hohe Wärmeleitfähigkeit aufweisen um den Wärmetransport, der von den Halbleitern verursacht wird, nicht zu beeinträchtigen.

In einer besonders günstigen Ausgestaltung der Erfindung ist es außerdem vorgesehen, dass eine Mehrzahl von n-dotierten Halbleitern und p-dotierten Halbleitern jeweils abwechselnd innerhalb einer Halbleiteranordnung angeordnet ist.

Eine Mehrzahl von n-dotierten und p-dotierten Halbleitern erhöht die Wärmetransportkapazität der einzelnen Halbleiteranordnungen und damit der Peltierelemente. Die Halbleiter müssen, um die Funktionsfähigkeit des Wärmeübertragers zu gewährleisten, derart angeordnet sein, dass immer abwechselnd ein n-dotierter und ein p-dotierter Halbleiter vom Strom durchflossen wird. Erfindungsgemäß ist vorgesehen, dass der Wärmeübertrager eine Mehrzahl von Peltierelementen aufweist, die untereinander elektrisch in Reihe geschaltet sind.

Eine Mehrzahl von Peltierelementen ist vorteilhaft, da die Wärmetransportkapazität insgesamt hierdurch erhöht wird. Außerdem kann über die Serienschaltung mehrerer Peltierelemente das Spannungsniveau der Gesamtanordnung auf ein anwendungstypisches Niveau (z.B. 12V oder 48V) angehoben werden. Jedes Peltierelement für sich arbeitet bei parallel geschalteten Halbleiteranordnungen und in Folge dessen weniger in Reihe geschalteten Schenkelpaaren auf einem niedrigeren Spannungsniveau, Die Heiz- und Kühlleistung wird hierdurch aber gegenüber einem Peltierelement gleicher Materialien, Schenkelanzahl und -geometrie mit ausschließlicher Reihenschaltung nicht nennenswert verändert. Beispielsweise bleibt der sehr geringfügige Spannungsabfall und der Stromfluss an einem einzelnen P/N-Schenkelpaar weitgehend unbeeinflusst. Stattdessen ergibt sich die nunmehr höhere Gesamtstromstärke des Peltierelementes als Produkt des Stromes einer Halbleiteranordnung mal der Anzahl der parallelen Halbleiteranordnungen.

Weiterhin ist es zu bevorzugen, wenn die Isolationselemente als flächig ausgedehnte plattenähnliche Elemente ausgeführt sind.

Flächig ausgedehnte plattenähnliche Elemente sind besonders vorteilhaft um daran zu kühlende oder zu erwärmende Elemente anzubinden. Die Isolationselemente können dabei als Träger für die zu kühlenden und/oder die zu erwärmenden Elemente genutzt werden.

Darüber hinaus kann es vorteilhaft sein, wenn innerhalb eines Peltierelementes parallel geschaltete Halbleiteranordnungen und in Reihe geschaltete Halbleiteranordnungen angeordnet sind.

Durch eine Kombination von in Reihe geschalteten Halbleiteranordnungen und parallel geschalteten Halbleiteranordnungen kann die Ausfallsicherheit eines Peltierelementes erhöht werden, und gleichzeitig die Absenkung des Spannungsniveaus, welche sich infolge der Parallelschaltung ergibt, möglichst minimal gehalten werden.

Gemäß einer besonders bevorzugten Weiterbildung der Erfindung kann es vorgesehen sein, dass sie eine Regeleinrichtung aufweist, welche Gesamtwiderstände einzelner Halbleiteranordnungen und/oder Gesamtwiderstände einzelner Peltierelemente misst und die gemessenen IST-Werte mit hinterlegten SOLL-Werten abgleicht und ausgehend von dem Ergebnis eine Regelung der angelegten Spannung an einer oder mehreren Halbleiteranordnungen und/oder an einem oder mehreren Peltierelementen vornimmt.

Eine Regeleinrichtung ist insbesondere vorteilhaft, wenn aufgrund eines Defektes an einem oder mehreren Halbleitern, einzelne oder mehrere Leitungswege für den Strom, welcher den Wärmeübertrager durchfließt, blockiert werden. Dies führt zu einer Veränderung der Widerstände der Halbleiter, der Halbleiteranordnungen und der Peltierelemente. Über eine aktive Regulierung der angelegten Spannung können Einbußen bei der möglichen Wärmetransportkapazität kompensiert werden.

Vorteilhafte Weiterbildungen der vorliegenden Erfindung sind in den Unteransprüchen und der nachfolgenden Figurenbeschreibung beschrieben.

### Kurze Beschreibung der Zeichnungen

Im Folgenden wird die Erfindung anhand von Ausführungsbeispielen unter Bezugnahme auf die Zeichnungen detailliert erläutert. In den Zeichnungen zeigen:
- Fig.1: eine Ansicht einer Halbleiteranordnung mit einer Mehrzahl von n-dotierten Halbleitern und einer Mehrzahl von p-dotierten Halbleitern, die über Leitungsbrücken miteinander in Reihe verschaltet sind,
- Fig. 2: eine Aufsicht auf zwei Peltierelemente, die jeweils aus einer Mehrzahl von Halbleiteranordnungen aufgebaut sind, die sich in parallel zueinander liegenden Reihen entlang des Peltierelementes erstrecken, wobei die Halbleiteranordnungen jedes Peltierelementes parallel zueinander geschaltet sind und die Peltierelemente zueinander in Reihe geschaltet sind, und
- Fig. 3: eine Aufsicht auf einen Wärmeübertrager, der aus einer Mehrzahl von Peltierelementen besteht, die zueinander in Reihe geschaltet sind.

### Bevorzugte Ausführung der Erfindung

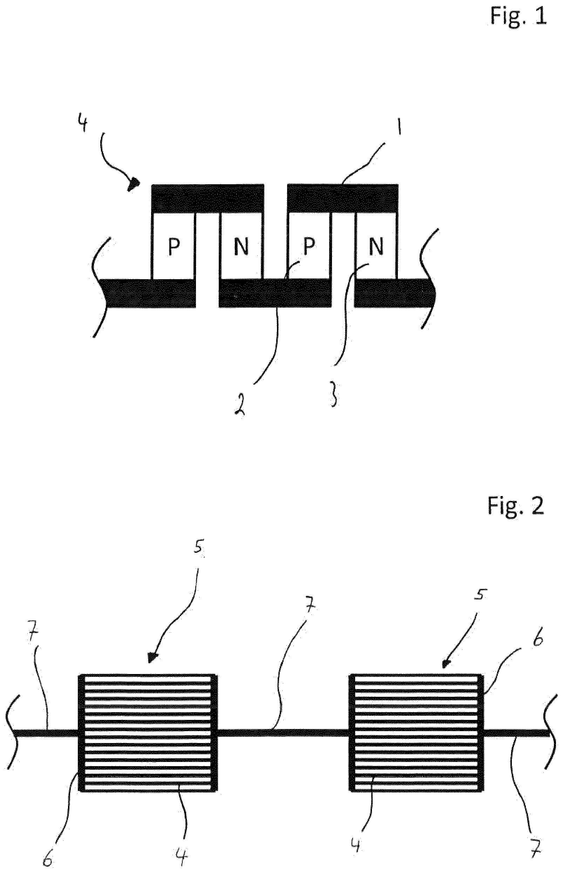

Die Fig. 1 zeigt eine schematische Ansicht einer Halbleiteranordnung 4. Die Halbleiteranordnung 4 besteht im Wesentlichen aus Brückenelementen 1 sowie einer Mehrzahl von p-dotierten Halbleitern 2 sowie n-dotierten Halbleitern 3.

Die Halbleiteranordnung 4 in der Fig. 1 zeigt eine Anordnung, welche abwechselnd einen p-dotierten Halbleiter 2 sowie einen n-dotierten Halbleiter 3 vorsieht. Jeweils ein p-dotierter Halbleiter 2 ist über ein Brückenelement 1 mit einem benachbart liegenden n-dotierten Halbleiter 3 verbunden. Die einzelnen p-dotierten Halbleiter 2 und n-dotierten Halbleiter 3 sind miteinander in Reihe geschaltet.

Wie in der Fig. 1 angedeutet, ist der gezeigte Abschnitt der Halbleiteranordnung 4 nur ein Ausschnitt aus einer möglicherweise wesentlich größeren Halbleiteranordnung. Die Halbleiteranordnung 4 kann sich sowohl nach links als auch nach rechts noch weiter über den gezeigten Bereich hinaus erstrecken.

Die Halbleiteranordnung 4 kann sich, wie in Fig. 1 dargestellt, in einer Reihe erstrecken, welche beispielsweise einer Geraden folgt. Ebenso gut kann eine Halbleiteranordnung jedoch auch mehrere Aneinanderreihungen von in Reihe geschalteten p-dotierten Halbleitern 2 und n-dotierten Halbleitern 3 beinhalten.

Über das Anlegen einer Spannung an die Brückenelemente 1 wird innerhalb der Halbleiteranordnung 4 ein Wärmetransport ausgelöst, welcher dazu führt, dass sich jeweils eine Seite der p-dotierten Halbleiter 2 und der n-dotierten Halbleiter 3 erwärmt und die dieser Seite gegenüberliegende Seite dabei abkühlt. Die p-dotierten Halbleiter 2 und n-dotierten Halbleiter 3 sind dabei so angeordnet, dass die sich abkühlende Seite sowie die sich erwärmende Seite jeweils in die gleiche Richtung orientiert ist. Bei der in Fig. 1 gezeigten Halbleiteranordnung 4 erwärmt sich beispielsweise die obere Seite der p-dotierten Halbleiter 2 und n-dotierten Halbleiter 3, während sich die untere Seite abkühlt. Durch eine Änderung der Polarität des fließenden Stroms wird entsprechend die obere Seite abgekühlt und die untere Seite erwärmt.

Um einen guten Wärmetransport sicherzustellen, ist es vorteilhaft, wenn die Brückenelemente 1 eine hohe thermische Leitfähigkeit aufweisen.

Die Halbleiteranordnung 4 kann in einer alternativen Ausführungsform zwischen zwei Isolationselementen angeordnet sein. Die Isolationselemente dienen der elektrischen Isolation der Halbleiteranordnung nach außen hin und können gleichzeitig der Anbindung von zu kühlenden oder zu erwärmenden Elementen dienen. Die Isolationselemente sind dabei vorteilhafterweise so angebracht, dass die Brückenelemente mit den Isolationselementen in thermisch leitendem Kontakt stehen. Die Isolationselemente weisen bevorzugt eine hohe Wärmeleitfähigkeit auf, so dass ein Wärmetransport durch die Isolationselemente möglichst ungehindert stattfinden kann.

Die Fig. 2 zeigt zwei Peltierelemente 5, welche jeweils aus einer Mehrzahl von Halbleiteranordnungen 4 bestehen. Die einzelnen Peltierelemente 5 sind zueinander über die Stromleiter 7 in Reihe geschaltet. Innerhalb der Peltierelemente 5 sind Reihen von Halbleiteranordnungen 4 vorgesehen, welche sich parallel zueinander entlang des Peltierelementes erstrecken. In abweichenden Ausführungen können die Halbleiteranordnungen auch in einer abweichenden Anordnung innerhalb des Peltierelementes angeordnet sein.

Die Halbleiteranordnungen 4 können im einfachsten Fall aus jeweils einer Reihe hintereinander geschalteten p-dotierter Halbleiter 2 sowie n-dotierter Halbleiter 3 bestehen, welche über Brückenelemente miteinander verbunden sind. Ebenso ist es auch möglich, mehrere p-dotierte Halbleiter 2 und n-dotierte Halbleiter 3 nebeneinander zu einer Halbleiteranordnung 4 zusammenzufassen. Die Halbleiteranordnungen 4 bilden dabei innerhalb des Peltierelementes 5 jeweils eine für sich geschlossene Einheit. Die einzelnen Halbleiteranordnungen 4 sind innerhalb des Peltierelementes 5 parallel zueinander geschaltet. Die Verteilung des Stroms auf die einzelnen parallel geschalteten Halbleiteranordnungen 4 erfolgt über die Stromleiter 6.

Die parallele Anordnung der Halbleiteranordnungen 4 innerhalb eines Peltierelementes 5 ist insbesondere vorteilhaft, da die Ausfallwahrscheinlichkeit eines gesamten Peltierelementes 5 dadurch deutlich reduziert wird. Sollte ein einzelnes p-dotiertes Halbleiterelement 2, ein n-dotiertes Halbleiterelement 3 oder ein einzelnes Brückenelement 1 beschädigt werden, wird nur der Stromfluss innerhalb einer Halbleiteranordnung 4 unterbrochen. Durch die Parallelschaltung mehrerer Halbleiteranordnungen 4 bleibt der Stromfluss durch das Peltierelement 5 insgesamt weiterhin erhalten. Das Peltierelement 5 verliert in diesem Fall lediglich die Wärmetransportleistung einer Halbleiteranordnung 4.

Das Peltierelement 5 ist damit wesentlich robuster und ausfallsicherer als ein Peltierelement, welches aus einer reinen Reihenschaltung von p-dotierten Halbleitern und n-dotierten Halbleitern aufgebaut ist.

In Fig. 2 ist lediglich ein Ausschnitt einer größeren Menge von Peltierelementen 5 dargestellt. Ein einzelnes Peltierelement 5 oder eine Mehrzahl von Peltierelementen 5 kann dabei einen Wärmeübertrager darstellen, welcher zum Heizen oder zum Kühlen von Elementen, beispielsweise in einem Kraftfahrzeug, eingesetzt werden kann.

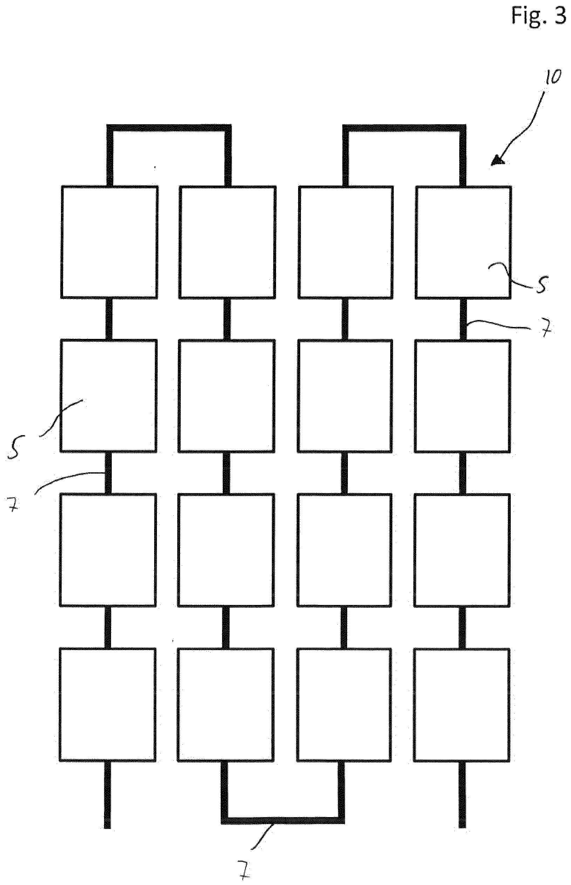

Die Fig. 3 zeigt einen Wärmeübertrager 10, der aus einer Anordnung von 16 Peltierelementen 5 besteht. Der Aufbau der einzelnen Peltierelemente 5 entspricht dem in Fig. 2 beschriebenen Aufbau von parallel zueinander geschalteten Halbleiteranordnungen 4 innerhalb des Peltierelementes 5 sowie einer Reihenschaltung der einzelnen Peltierelemente 5 zueinander. Die Peltierelemente 5 sind über die Stromleiter 7 miteinander in Reihe geschaltet.

Die in Fig. 3 gezeigte Anordnung von 16 Peltierelementen 5 in jeweils vier Reihen ist beispielhaft. Eine von dieser Anzahl abweichende Anzahl von Peltierelementen ist jederzeit vorsehbar. Ebenso ist eine von der in Fig. 3 abweichende Anordnung vorsehbar. Solange die einzelnen Peltierelemente 5 untereinander in Serie geschaltet sind und der innere Aufbau der Peltierelemente 5 dem Aufbau der Fig. 2 entspricht, ist eine nahezu beliebige Gestaltungsmöglichkeit für den Wärmeübertrager 10 gegeben.

In alternativen Ausführungsformen ist es ebenso vorsehbar, mehrere Peltierelemente parallel zueinander zu schalten und eine Anordnung von mehreren parallel geschalteten Peltierelementen mit einer weiteren Anordnung von einzelnen oder mehreren Peltierelementen in Reihe zu schalten. Die Peltierelemente 5 können entweder jeweils für sich Isolationselemente aufweisen, welche die Halbleiteranordnung 4 nach oben bzw. nach unten hin abschließen, ebenso ist es auch vorsehbar, eine Mehrzahl von Peltierelementen zwischen einem gemeinsamen oberen und einem gemeinsamen unteren Isolationselement anzuordnen.

Die dargestellten Ausführungsformen stellen jeweils nur Beispiele dar und dienen dem besseren Verständnis des Aufbaus des Wärmeübertragers 10 bzw. der Peltierelemente 5. Sie besitzen keinen beschränkenden Charakter.

## Patentansprüche

1. Wärmeübertrager (10), welcher zumindest ein erstes Peltierelement (5) aufweist, wobei das Peltierelement (5) eine erste Halbleiteranordnung (4) und zumindest eine zweite Halbleiteranordnung (4) aufweist, wobei jede Halbleiteranordnung (4) einen ersten Halbleiter, einen zweiten Halbleiter und eine elektrische Kontaktierung aufweist, wobei jeweils zumindest ein Halbleiter jeder Halbleiteranordnung (4) aus einem p-dotierten Halbleitermaterial (2) gefertigt ist und jeweils zumindest ein Halbleiter aus einem n-dotierten Halbleitermaterial (3) gefertigt ist, wobei jeweils ein n-dotierter Halbleiter (2) und ein p-dotierter Halbleiter (3) innerhalb der Halbleiteranordnung (4) abwechselnd elektrisch in Reihe geschaltet sind und über die elektrische Kontaktierung eine Spannung an sie anlegbar ist, **dadurch gekennzeichnet, dass** die beiden Halbleiteranordnungen (4) elektrisch parallel zueinander geschaltet sind, wobei der Wärmeübertrager (10) eine Mehrzahl von Peltierelementen (5) aufweist, die untereinander elektrisch in Reihe geschaltet sind.

2. Wärmeübertrager (10) nach Anspruch 1, **dadurch gekennzeichnet, dass** die Halbleiter (2, 3) innerhalb der Halbleiteranordnungen (4) über elektrisch leitende Brückenelemente (1) miteinander verschaltet sind.

3. Wärmeübertrager (10) nach einem der vorhergehenden Ansprüche, **dadurch gekennzeichnet, dass** beim Anlegen einer Spannung sich jeweils ein erster Endbereich der Halbleiter (2, 3) erwärmt und ein diesem Endbereich gegenüberliegender Endbereich abkühlt, wobei die Halbleiter (2, 3) derart angeordnet sind, dass die sich erwärmenden und die sich abkühlenden Bereiche jeweils in die gleiche Richtung orientiert sind.

4. Wärmeübertrager (10) nach einem der vorhergehenden Ansprüche, **dadurch gekennzeichnet, dass** jedes Peltierelement (5) ein erstes Isolationselement und ein zweites Isolationselement aufweist, wobei die Halbleiter (2, 3) zwischen den Isolationselementen in einer Ebene angeordnet sind und die Halbleiter (2, 3) in thermisch leitenden Kontakt mit den elektrisch leitenden Brückenelementen (1) und/oder den Isolationselementen sind.

5. Wärmeübertrager (10) nach einem der vorhergehenden Ansprüche, **dadurch gekennzeichnet, dass** eine Mehrzahl von n-dotierten Halbleitern (2) und p-dotierten Halbleitern (3) jeweils abwechselnd innerhalb einer Halbleiteranordnung (4) angeordnet ist.

6. Wärmeübertrager (10) nach einem der vorhergehenden Ansprüche, **dadurch gekennzeichnet, dass** die Isolationselemente als flächig ausgedehnte plattenähnliche Elemente ausgeführt sind.

7. Wärmeübertrager (10) nach einem der vorhergehenden Ansprüche, **dadurch gekennzeichnet, dass** innerhalb eines Peltierelementes (5) parallel geschaltete Halbleiteranordnungen (4) und in Reihe geschaltete Halbleiteranordnungen angeordnet sind.

8. Wärmeübertrager (10) nach einem der vorhergehenden Ansprüche, **dadurch gekennzeichnet, dass** er eine Regeleinrichtung aufweist, welche Gesamtwiderstände einzelner Halbleiteranordnungen (4) und/oder Gesamtwiderstände einzelner Peltierelemente (5) misst und die gemessenen IST-Werte mit hinterlegten SOLL-Werten abgleicht und ausgehend von dem Ergebnis eine Regelung der angelegten Spannung an einer oder mehreren Halbleiteranordnungen (4) und/oder an einem oder mehreren Peltierelementen (5) vornimmt.

## Claims

1. A heat exchanger (10), which has at least one first Peltier element (5), wherein the Peltier element (5) has a first semiconductor arrangement (4) and at least one second semiconductor arrangement (4), wherein each semiconductor arrangement (4) has a first semiconductor, a second semiconductor, and an electrical contact, wherein in each case at least one semiconductor of each semiconductor arrangement (4) is manufactured from a p-doped semiconductor material (2) and in each case at least one semiconductor is manufactured from an n-doped semiconductor material (3), wherein in each case an n-doped semiconductor (2) and a p-doped semiconductor (3) are alternately electrically connected in series inside the semiconductor arrangement (4) and a voltage can be applied thereto via the electrical contact, **characterised in that** the two semiconductor arrangements (4) are electrically connected in parallel to one another, wherein the heat exchanger (10) has a plurality of Peltier elements (5) which are electrically connected in series to one another.

2. The heat exchanger (10) as claimed in claim 1, **characterised in that** the semiconductors (2, 3) are interconnected inside the semiconductor arrangements (4) via electrically conductive bridge elements (1).

3. The heat exchanger (10) as claimed in any one of the preceding claims, **characterised in that**, upon application of a voltage, a first end region of the semiconductors (2, 3) heats up and an end region opposite to this end region cools down in each case, wherein the semiconductors (2, 3) are arranged such that the heating and cooling regions are each oriented in the same direction.

4. The heat exchanger (10) as claimed in any one of the preceding claims, **characterised in that** each Peltier element (5) has a first insulation element and a second insulation element, wherein the semiconductors (2, 3) are arranged between the insulation elements in a plane and the semiconductors (2, 3) are in thermally conductive contact with the electrically conductive bridge elements (1) and/or the insulation elements.

5. The heat exchanger (10) as claimed in any one of the preceding claims, **characterised in that** a plurality of n-doped semiconductors (2) and p-doped semiconductors (3) are arranged alternately inside a semiconductor arrangement (4) in each case.

6. The heat exchanger (10) as claimed in any one of the preceding claims, **characterised in that** the insulation elements are embodied as flatly extended plate-like elements.

7. The heat exchanger (10) as claimed in any one of the preceding claims, **characterised in that** semiconductor arrangements (4) connected in parallel and semiconductor arrangements connected in series are arranged inside a Peltier element (5).

8. The heat exchanger (10) as claimed in any one of the preceding claims, **characterised in that** it has a regulating unit, which measures overall resistances of individual semiconductor arrangements (4) and/or overall resistances of individual Peltier elements (5) and compares the measured ACTUAL values to stored SETPOINT values and, proceeding from the result, performs a regulation of the applied voltage to one or more semiconductor arrangements (4) and/or to one or more Peltier elements (5).

## Revendications

1. Echangeur de chaleur (10) qui comprend au moins un premier élément Peltier (5), où l'élément Peltier (5) présente un premier agencement de semi-conducteurs (4) et au moins un deuxième agencement de semi-conducteurs (4), où chaque agencement de semi-conducteurs (4) comprend un premier semi-conducteur, un deuxième semi-conducteur et une mise en contact électrique, où à chaque fois au moins un semi-conducteur de chaque agencement de semi-conducteurs (4) est fabriqué en étant composé d'un matériau semi-conducteur (2) dopé p, et à chaque fois au moins un semi-conducteur est fabriqué en étant composé d'un matériau semi-conducteur (3) dopé n, où un semi-conducteur (2) dopé p et un semi-conducteur (3) dopé n sont à chaque fois montés électriquement en série, de façon alternée, à l'intérieur de l'agencement de semi-conducteurs (4), et une tension peut être appliquée auxdits semi-conducteurs par la mise en contact électrique, **caractérisé en ce que** les deux agencements de semi-conducteurs (4) sont montés électriquement en étant parallèles l'un à l'autre, où l'échangeur de chaleur (10) présente une pluralité d'éléments Peltier (5) qui sont connectés électriquement en série les uns aux autres.

2. Echangeur de chaleur (10) selon la revendication 1, **caractérisé en ce que** les semi-conducteurs (2, 3), à l'intérieur des agencements de semi-conducteurs (4), sont connectés l'un à l'autre par des éléments de pontage (1) électroconducteurs.

3. Echangeur de chaleur (10) selon l'une des revendications précédentes, **caractérisé en ce que**, au cours de l'application d'une tension, une première zone d'extrémité des semi-conducteurs (2, 3) se réchauffe à chaque fois, et une zone d'extrémité placée à l'opposé de cette zone d'extrémité se refroidit, où les semi-conducteurs (2, 3) sont disposés de manière telle, que les zones se réchauffant et se refroidissant sont orientées à chaque fois dans la même direction.

4. Echangeur de chaleur (10) selon l'une quelconque des revendications précédentes, **caractérisé en ce que** chaque élément Peltier (5) présente un premier élément isolant et un deuxième élément isolant, où les semi-conducteurs (2, 3) situés entre les éléments isolants sont disposés dans un plan, et les semi-conducteurs (2, 3) sont en contact thermoconducteur avec les éléments de pontage (1) électroconducteurs et / ou avec les éléments isolants.

5. Echangeur de chaleur (10) selon l'une quelconque des revendications précédentes, **caractérisé en ce qu'**une pluralité de semi-conducteurs (2) dopés p et de semi-conducteurs (3) dopés n est disposée à chaque fois de façon alternée à l'intérieur d'un agencement de semi-conducteurs (4).

6. Echangeur de chaleur (10) selon l'une quelconque des revendications précédentes, **caractérisé en ce que** les éléments isolants sont réalisés comme des éléments semblables à des plaques étendues à plat.

7. Echangeur de chaleur (10) selon l'une quelconque des revendications précédentes, **caractérisé en ce que** des agencements de semi-conducteurs (4) montés en parallèle et des agencements de semi-conducteurs montés en série sont disposés à l'intérieur d'un élément Peltier (5).

8. Echangeur de chaleur (10) selon l'une quelconque des revendications précédentes, **caractérisé en ce qu'**il présente un dispositif de réglage qui mesure des résistances totales de différents agencements de semi-conducteurs (4) et / ou des résistances totales de différents éléments Peltier (5) et qui ajuste les valeurs RÉELES mesurées, par rapport à des valeurs THÉORIQUES mémorisées, et qui, à partir du résultat, procède à un réglage de la tension appliquée à un ou plusieurs agencement(s) de semi-conducteurs (4) et / ou à un ou plusieurs élément(s) Peltier (5).
